# EUROPEAN PATENT SPECIFICATION

(11) **EP 3 836 207 B1**
(45) Date of publication and mention of the grant of the patent: **27.07.2022**
(21) Application number: 19215556.2
(22) Date of filing: 12.12.2019
(51) Int. Cl.: H01L 23/48, H01Q 23/00, H01Q 1/22, H01L 25/16, H01L 23/66, H01L 23/522, H01Q 13/10, H01Q 19/06, H01Q 21/00, H01Q 21/06, H01L 23/00, H01L 25/065

(54) **SEMICONDUCTOR STRUCTURE AND METHOD FOR MANUFACTURING A SEMICONDUCTOR STRUCTURE**
HALBLEITERSTRUKTUR UND VERFAHREN ZUR HERSTELLUNG EINER HALBLEITERSTRUKTUR
STRUCTURE À SEMICONDUCTEURS ET PROCÉDÉ DE FABRICATION D'UNE STRUCTURE À SEMICONDUCTEURS

(43) Date of publication of application: 16.06.2021
(73) Proprietor: Technische Universität Dresden, 01069 Dresden (DE); IHP GmbH-Innovations for High Performance Microelectronics / Leibniz-Institut für innovative Mikroelektronik, 15236 Frankfurt / Oder (DE)
(72) Inventor: CARTA, Corrado, 01097 Dresden (DE); PANIC, Goran, 15236 Frankfurt (DE); KLUKAS, Ralf, 01723 Mohorn (DE)
(74) Representative: Viering, Jentschura & Partner mbB Patent- und Rechtsanwälte

(56) References cited:
- EP-A1- 3 346 549
- WO-A1-2017/167987
- CN-A- 108 390 153
- JP-A- H07 240 621
- US-A1- 2007 164 420
- US-A1- 2012 287 008
- US-A1- 2018 254 550
- US-A1- 2019 103 680
- US-A1- 2019 280 368
- HAHNEL R ET AL: "Distributed on-chip antennas to increase system bandwidth at 180 GHz", 2016 GERMAN MICROWAVE CONFERENCE (GEMIC), INSTITUT FÜR MIKROWELLEN UND ANTENNENTECHNIK - IMA, 14 March 2016 (2016-03-14), pages 161-164, XP032896911, DOI: 10.1109/GEMIC.2016.7461580

## Description

Various embodiments generally relate to a semiconductor structure and a method for manufacturing a semiconductor structure.

Radio frequency components, such as antenna elements, may be part of a semiconductor structure manufactured on a substrate. However, there may be coupling effects between the radiated waves and the substrate, such as a low-resistivity silicon substrate, leading to a reduced gain of the antenna. Thus, it may be necessary to provide a radio frequency components including semiconductor structure with reduced coupling effects.

Previous approaches for decreasing the coupling and thus increasing the gain of an antenna are, for example, based on high resistivity substrates. However, several semiconductor processing technologies rely on low resistivity substrates. JP H07 240 621 A describes an antenna device including a conductor plate on a first side of a first substrate, a resonator formed in the first substrate, a second substrate having a first side facing a second side of the first substrate, wherein the second side is opposite the first side of the first substrate, a second conductor plate on a second side of the second substrate, the second side is opposite the first side of the second substrate, wherein the antenna device further includes a power feeding line formed in the first substrate and connected to the resonator.

US2007/0164420 A1 describes an apparatus and methods for integrally packaging antenna devices with semiconductor IC (integrated circuit) chips, wherein IC chips are packaged with dielectric resonators antennas that are integrally constructed as part of a package molding (encapsulation) process, for example, to form compact integrated radio/ wireless communications systems for millimeter wave applications.

A semiconductor structure is disclosed as recited in claim 1.

An antenna chip comprising the semiconductor structure as recited in claim 1 is disclosed as recited in claim 5.

A system-in-package, comprising the antenna chip as recited in claim 5 and a radio frequency integrated circuit chip is disclosed as recited in claim 6.

A method for manufacturing a semiconductor structure is disclosed as recited in claim 7.

Methods for mounting the antenna chip as recited in claim 5 and a radio frequency integrated circuit chip on a printed circuit board are disclosed as recited in claims 11 and 12.

Further embodiments are recited in dependent claims.

In various embodiments, an antenna element including semiconductor structure is provided, wherein the antenna element radiates towards the substrate, and wherein the substrate is structured as a dielectric resonator leading to reduced coupling effects and an increased gain of the antenna.

The semiconductor structure with the features of the independent claim 1 (first example) provides an antenna structure with an increased gain.

The semiconductor material may be, for example, silicon, for example, doped silicon. The substrate may include a resistivity in the range from about 0.002 Qcm to about 75 Qcm, for example about 30 Qcm or higher than 30 Qcm. The substrate may include a relative permittivity in the range from about 7 to about 16. The substrate may have a thickness in the range from about 100 µm to about 975 µm, for example 100 µm to 600 µm. The features mentioned in this paragraph in combination with the first example provide a second example.

The metal layer stack may further include a ground plane. The feature mentioned in this paragraph in combination with the first example or the second example provides a third example.

The antenna element may include at least one radiation slot, wherein the radiation slot may include an opening in the metal stack layer. In other words, the antenna element may be a slot-based antenna element. The at least one radiation slot may be structured in one of the following shapes: rectangular, tapered, or curved. The dielectric resonator may resonate at the target frequency. The target frequency may be in the range from about 30 to about 500 GHz. The at least one radiation slot may have a length of about half of the wavelength (for example in the range from about one quarter to about one half of the wavelength). The length of the radiation slot may be selected depending on the dielectric layers (for example stack of dielectric layers), such as the effective permittivity of the dieletric layers. The at least one radiation slot may have a width in the range from about 10 percent to about 15 percent of the length of the at least one radiation slot. The antenna element may radiate through the at least one radiation slot. The antenna element may include at least one slot ground contact via, wherein the at least one slot ground contact via may be disposed along the edges of the at least one radiation slot. The features mentioned in this paragraph in combination with any one of the first example to the third example provide a fourth example.

The antenna element may include at least one transmission line. The transmission line may be a microstrip line, a coplanar wave guide, or a combination thereof, wherein the combination of a microstrip line and a coplanar wave guide may be a grounded coplanar wave guide. The at least one transmission line may feed the at least one radiation slot. The features mentioned in this paragraph in combination with any one of the first example to the fourth example provide a fifth example.

The antenna element may further include at least one shorting pin. The at least one shorting pin may be disposed between the at least one transmission line and the at least one radiation slot. The features mentioned in this paragraph in combination with any one of the first example to the fifth example provide a sixth example.

The antenna element may further include at least one feeding contact. The at least one feeding contact may feed the at least one transmission line. The at least one feeding contact may be disposed in the central part of the semiconductor structure. The at least one feeding contact may include at least one feeding contact pad. The features mentioned in this paragraph in combination with any one of the first example to the sixth example provide a seventh example.

The antenna element may further include at least one ground contact. The at least one ground contact may include at least one ground contact pad. The antenna element may further include at least one ground contact via. The at least one ground contact via may connect the at least one ground contact to the ground plane. The features mentioned in this paragraph in combination with any one of the first example to the seventh example provide an eighth example.

The antenna element may further include at least one antenna opening structure. The feature mentioned in this paragraph in combination with any one of the first example to the eighth example provides a ninth example.

The dielectric resonator may enhance (in other words may shape, focus, or direct) the radiation radiated by the antenna element. The dielectric resonator may be structured in one of the following shapes: dipole, square, rectangular, triangular, circle, ring, elliptic, or n-tagonal, such as pentagonal, hexagonal, octagonal etc. The dielectric resonator may be disposed such that the radiation slot is covered by the dielectric resonator. The features mentioned in this paragraph in combination with any one of the first example to the ninth example provide a tenth example.

The semiconductor structure may include a plurality of antenna elements. The plurality of antenna elements may realize a phased array antenna (for example the plurality of antenna elements may be part of a phased array antenna). The semiconductor structure may further include a plurality of dielectric resonators. Each dielectric resonator of the plurality of dielectric resonators may be assigned to an antenna element of the plurality of antenna elements. The plurality of dielectric resonators may form an array of dielectric resonators. The features mentioned in this paragraph in combination with any one of the first example to the tenth example provide an eleventh example.

The semiconductor structure may further include a substrate opening structure. The substrate opening structure may be disposed such that each dielectric resonator of the plurality of dielectric resonators is separated from any other dielectric resonator of the plurality of dielectric resonators. The features mentioned in this paragraph in combination with the eleventh example provide a twelfth example.

The semiconductor structure may further include an interconnection structure. The interconnection structure may include at least one substrate rail. This has the effect of stabilizing, for example structurally stabilizing, the semiconductor structure, for example as a chip structure. The at least one substrate rail may be disposed between two adjacent dielectric resonators. The at least one substrate rail may be in contact with the two adjacent dielectric resonators. The at least one substrate rail may be disposed between the centerlines of two adjacent dielectric resonators and/or may be disposed between the edge lines of two adjacent dielectric resonators. The features mentioned in this paragraph in combination with the twelfth example provide a thirteenth example.

The interconnection structure may include a plurality of substrate rails. Each substrate rail of the plurality of substrate rails may be disposed between two adjacent dielectric resonators of the plurality of dielectric resonators and each substrate rail of the plurality of substrate rails may be in contact with the two adjacent dielectric resonators. Each substrate rail of the plurality of substrate rails may be disposed between the centerlines of two adjacent dielectric resonators of the plurality of dielectric resonators and/or may be disposed between the edge lines of two adjacent dielectric resonators of the plurality of dielectric resonators. The features mentioned in this paragraph in combination with the thirteenth example provide a fourteenth example.

The plurality of substrate rails may include first substrate rails and second substrate rails, wherein first substrate rails may be disposed between the centerlines of two adjacent dielectric resonators and wherein second substrate rails may be disposed between the edge lines of two adjacent dielectric resonators. The features mentioned in this paragraph in combination with the fourteenth example provide a fifteenth example.

The plurality of dielectric resonators may form an array of dielectric resonators and the plurality of dielectric resonators may include first substrate rails in a first direction of the array of dielectric resonators and second substrate rails in a second direction of the array of dielectric resonators. The first direction of the array of dielectric resonators may be the horizontal in-plane direction and the second direction of the array of dielectric resonators may be the vertical in-plane direction. The features mentioned in this paragraph in combination with the fifteenth example provide a sixteenth example.

The semiconductor structure may further include at least one dummy dielectric resonator. The at least one dummy dielectric resonator may be in contact with at least one dielectric resonator via the interconnection structure. The features mentioned in this paragraph in combination with any one of the thirteenth example to the sixteenth example provide a seventeenth example.

The semiconductor structure may include a plurality of dummy dielectric resonators. Each dummy dielectric resonator of the plurality of dummy dielectric resonators may be in contact with at least one dielectric resonator and/or at least one dummy dielectric resonator via the interconnection structure.

The plurality of dummy dielectric resonators may be substantially surrounding the array of dielectric resonators. The features mentioned in this paragraph in combination with the seventeenth example provide an eighteenth example.

An antenna chip may include the semiconductor structure of any one of the first example to the eighteenth example. The antenna chip mentioned in this paragraph provides a nineteenth example.

A system-in-package includes an antenna chip and a radio frequency integrated circuit chip. The antenna chip includes a substrate, wherein the substrate includes a semiconductor material. The substrate includes a first side and a second side. The antenna chip further includes a metal layer stack disposed over the first side of the substrate. The metal layer stack includes a plurality of metallization layers and interdielectric layers and an antenna element formed in the metal layer stack. The antenna element is configured to align the main radiation direction of the antenna element in direction of the substrate. The second side of the substrate is configured as a dielectric resonator. The radio frequency integrated circuit chip includes a substrate and a radio frequency integrated circuit disposed at least partially within the substrate. The antenna chip is arranged over the radio frequency integrated circuit chip such that the metal layer stack of the antenna chip is facing the radio frequency integrated circuit of the radio frequency integrated circuit chip. In other words, the radio frequency integrated circuit chip may include a substrate, wherein the substrate may include a first side and a second side, wherein a metal layer stack may be disposed over the first side of the substrate of the radio frequency integrated circuit chip, and wherein the antenna chip may be arranged over the radio frequency integrated circuit chip such that the metal layer stack of the antenna chip is facing the metal layer stack of the radio frequency integrated circuit chip. The system-in-package mentioned in this paragraph provides a twentieth example.

The radio frequency integrated circuit may include a radio frequency transmitter and/or a radio frequency receiver. The radio frequency integrated circuit chip may further include a plurality of radio frequency contacts and the antenna element of the antenna chip may include a plurality of feeding contacts. The plurality of radio frequency contacts of the radio frequency integrated circuit chip may be aligned to the plurality of feeding contacts of the antenna chip. The plurality of radio frequency contacts of the radio frequency integrated circuit chip may be contacted to the plurality of feeding contacts of the antenna chip. The features mentioned in this paragraph in combination with the twentieth example provide a twenty-first example.

The radio frequency integrated circuit chip may include larger in-plane dimensions than the antenna chip. The radio frequency integrated circuit chip may include a first region and a second region, wherein the in-plane dimensions of the first region may correspond to the in-plane dimensions of the antenna chip. The second region may be not in contact with the antenna chip. The features mentioned in this paragraph in combination with the twentieth example or the twenty-first example provide a twenty-second example.

The radio frequency integrated circuit chip may include at least one additional contact. The at least one additional contact may be one of the following: DC, clock, and/or power supply contact/contacts. The at least one additional contact may be disposed in the second region of the radio frequency integrated circuit chip. The features mentioned in this paragraph in combination with the twenty-second example provide a twenty-third example.

The system-in-package may be attached to a printed circuit board such that the substrate of the radio frequency integrated circuit chip is in contact with the printed circuit board. The feature mentioned in this paragraph in combination with any one of the twentieth example to the twenty-third example provide a twenty-fourth example.

A method for manufacturing a semiconductor structure includes forming a metal layer stack over a first side of a semiconductor substrate. The metal layer stack includes a plurality of metallization layers and interdielectric layers and an antenna element formed in the metal layer stack. The antenna element is configured to align the main radiation direction of the antenna element in direction of the substrate. The method further includes structuring a second side of the semiconductor substrate as a dielectric resonator. The method mentioned in this paragraph provides a twenty-fifth example.

The structuring of the second side of the substrate may include an etching process. The etching process may be a local backside etching process. The method may further include a wafer thinning process. The features mentioned in this paragraph in combination with the twenty-fifth example provide a twenty-sixth example.

An antenna chip includes: a substrate, including a semiconductor material and including a first side and a second side; a metal layer stack disposed over the first side of the substrate, wherein the metal layer stack includes a plurality of metallization layers and interdielectric layers and wherein an antenna element is formed in the metal layer stack; at least one feeding contact disposed on top of the metal layer stack. The antenna element is configured to align the main radiation direction of the antenna element in direction of the substrate and the second side of the substrate is configured as a dielectric resonator. A radio frequency integrated circuit chip includes a substrate, including a first side and a second side; a radio frequency integrated circuit disposed at least partially over the first side of the substrate; a first region and a second region, wherein the in-plane dimensions of the first region corresponds to the in-plane dimensions of the antenna chip. The radio frequency integrated circuit includes at least one radio frequency contact in the first region and at least one additional contact, wherein the at least one additional contact is disposed in the second region. In other words, the radio frequency integrated circuit chip may include a metal layer stack disposed over the first side of the substrate of the radio frequency integrated circuit chip, wherein the at least one radio frequency contact and/or the at least one additional contact may be disposed on top of the metal layer stack of the radio frequency integrated circuit chip. A method for mounting the antenna chip and the radio frequency integrated circuit chip on a printed circuit board includes forming at least one solder ball over the at least one radio frequency contact of the radio frequency integrated circuit chip. The method further includes arranging the radio frequency integrated circuit chip over a printed circuit board. The method includes contacting the at least one additional contact. The method includes arranging the antenna chip over the radio frequency integrated circuit chip such that the at least one solder ball is contacting the at least one feeding contact of the antenna chip. The method mentioned in this paragraph provides a twenty-ninth example.

An antenna chip includes: a substrate, including a semiconductor material and including a first side and a second side; a metal layer stack disposed over the first side of the substrate, wherein the metal layer stack includes a plurality of metallization layers and interdielectric layers and wherein an antenna element is formed in the metal layer stack; at least one feeding contact disposed on top of the metal layer stack. The antenna element is configured to align the main radiation direction of the antenna element in direction of the substrate and the second side of the substrate may be configured as a dielectric resonator. A radio frequency integrated circuit chip includes a substrate, including a first side and a second side; a radio frequency integrated circuit disposed at least partially over the first side of the substrate; a first region and a second region, wherein the in-plane dimensions of the first region corresponds to the in-plane dimensions of the antenna chip. The radio frequency integrated circuit includes at least one radio frequency contact in the first region and at least one additional contact, wherein the at least one additional contact is disposed in the second region. In other words, the radio frequency integrated circuit chip may include a metal layer stack disposed over the first side of the substrate of the radio frequency integrated circuit chip, wherein the at least one radio frequency contact and/or the at least one additional contact may be disposed on top of the metal layer stack of the radio frequency integrated circuit chip. A method for mounting the antenna chip and the radio frequency integrated circuit chip on a printed circuit board includes arranging the radio frequency integrated circuit chip over a printed circuit board. The method includes contacting the at least one additional contact. The method further includes forming at least one solder ball over the at least one radio frequency contact of the radio frequency integrated circuit chip. The method includes arranging the antenna chip over the radio frequency integrated circuit chip such that the at least one solder ball is contacting the at least one feeding contact of the antenna chip. The method mentioned in this paragraph provides a thirtieth example.

The antenna chip may be arranged over the radio frequency integrated circuit chip such that the antenna chip is arranged above the first region of the radio frequency integrated circuit chip and not above the second region of the radio frequency integrated circuit chip. The features mentioned in this paragraph in combination with the twenty-ninth example or the thirtieth example provide a thirty-first example.

The method may further include depositing material with high electrical resistivity and low coupling properties over the radio frequency integrated circuit chip before arranging the antenna chip over the radio frequency integrated circuit chip. The features mentioned in this paragraph in combination with any one of the twenty-ninth example to the thirty-first example provide a thirty-second example.

Arranging the radio frequency integrated circuit chip over a printed circuit board may include arranging the radio frequency integrated circuit chip in a cavity of a printed circuit board. The feature mentioned in this paragraph in combination with any one of the twenty-ninth example to the thirty-second example provides a thirty-third example.

Contacting the at least one additional contact may include wire bonding. The feature mentioned in this paragraph in combination with any one of the twenty-ninth example to the thirty-third example provides a thirty-fourth example.

Arranging the antenna chip over the radio frequency integrated circuit chip may include a flip-chip bonding process. The feature mentioned in this paragraph in combination with any one of the twenty-ninth example to the thirty-fourth example provides a thirty-fifth example.

Various embodiments of the invention are described with reference to the following drawings, in which:
- Figure 1: shows a semiconductor structure according to various embodiments;
- Figure 2A: shows a top view of a semiconductor structure according to various embodiments;
- Figure 2B: shows a bottom view of a semiconductor structure according to various embodiments;
- Figure 3: shows a bottom view of a semiconductor structure according to various embodiments;
- Figure 4: shows a bottom view of a semiconductor structure according to various embodiments;
- Figure 5: shows a system-in-package according to various embodiments;
- Figure 6: shows a top view of an antenna chip and a radio frequency integrated circuit chip according to various embodiments;
- Figure 7: shows a method for manufacturing a semiconductor structure according to various embodiments;
- Figure 8A: shows a handling tool for handling a chip that includes a semiconductor structure according to various embodiments;
- Figure 8B: shows a handling tool for handling a chip that includes a semiconductor structure according to various embodiments;
- Figure 9A: shows a method for mounting an antenna chip according to various embodiments;
- Figure 9B: shows a method for mounting an antenna chip according to various embodiments;
- Figure 10A: shows a method for mounting an antenna chip according to various embodiments;
- Figure 10B: shows a method for mounting an antenna chip according to various embodiments.

The following detailed description refers to the accompanying drawings that show, by way of illustration, specific details and embodiments in which the invention may be practiced. These embodiments are described in sufficient detail to enable those skilled in the art to practice the invention. Other embodiments may be utilized and structural, logical, and electrical changes may be made without departing from the scope of the invention. The word "over", used herein to describe forming a feature, e.g. a layer "over" a side or surface, may be used to mean that the feature, e.g. the layer, may be formed "directly on", e.g. in direct contact with, the implied side or surface. The word "over", used herein to describe forming a feature, e.g. a layer "over" a side or surface, may be used to mean that the feature, e.g. the layer, may be formed "indirectly on" the implied side or surface with one or more additional layers being arranged between the implied side or surface and the formed layer. The term "lateral" used with regards to the "lateral" extension of a structure (or of a structure element) provided on or in a carrier (a substrate, a wafer, or another workpiece) or "laterally" next to, may be used herein to mean an extension or a positional relationship along a surface of the carrier. That means that a surface of a carrier (e.g. a surface of a substrate, a surface of a wafer, or a surface of another workpiece) may serve as reference, commonly referred to as the main processing surface. Further, the term "width" used with regards to a "width" of a structure (or of a structure element) may be used herein to mean the lateral extension of a structure. The term "thickness" used with regards to a "thickness" of a layer may be used herein to mean the spatial extension of the layer perpendicular to the surface of the support (the material or material structure) on which the layer is deposited. The term "coupled" is used herein to mean electrically connected, which may include a direct connection or an indirect connection, wherein an indirect connection may only include additional structures in the current path that not influence the substantial functioning of the described circuit or device. The terms "coupled" or "connected" may also include a physical connection. The terms "coupled" or "connected" may also include connections to transfer radio waves.

Various embodiments relate to an antenna structure on a substrate, wherein an antenna element radiates towards the substrate and wherein the substrate is configured as a dielectric resonator.

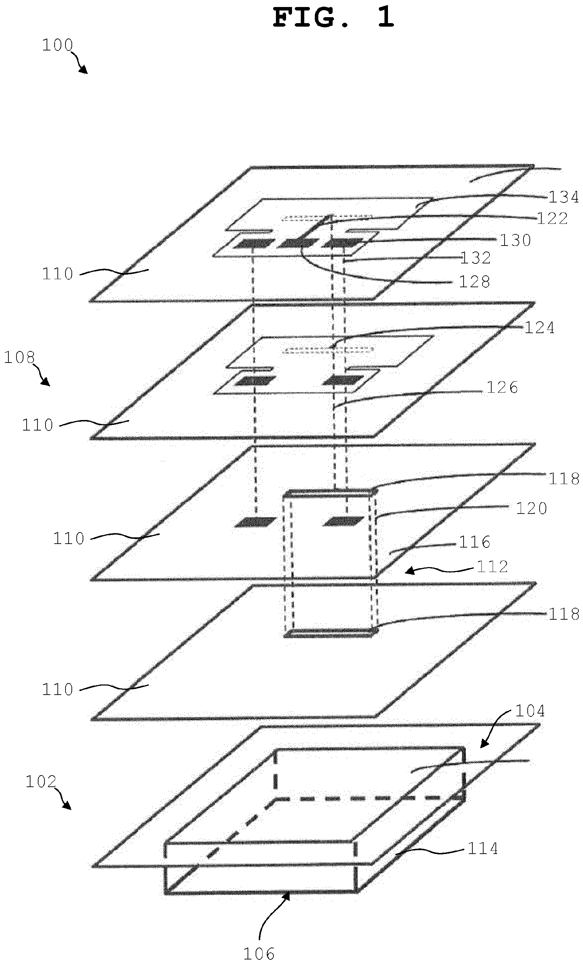

**FIG. 1** shows a semiconductor structure 100 according to various embodiments. The semiconductor structure 100 may include a substrate 102. The substrate 102 may be doped with doping atoms. The substrate 102 may include a semiconductor material, such as a semiconductor material with dielectric properties, for example silicon or doped silicon. The substrate 102 may include silicon. The substrate 102 may include doped silicon. The substrate 102 may have a resistivity in the range from about 0.0002 Qcm to about 75 Qcm, for example about 30 Ωcm or higher than 30 Qcm. The substrate 102 may have a relative permittivity in the range from about 7 to about 16. The substrate 102 may have a thickness in the range from about 100 µm to about 975 µm, for example 100 µm to 600 µm. The substrate 102 may include a first side 104 and a second side 106. The semiconductor structure 100 may include a metal layer stack 108. The metal layer stack 108 may be disposed over the first side 104 of the substrate 102. The metal layer stack 108 may include a plurality of metallization layers 110 and may include a plurality of interdielectric layers, wherein an interdielectric layer may be disposed between two metallization layers of the plurality of metallization layers 110. The metal layer stack 108 may include an antenna element 112. In other words, an antenna element 112 may be formed in the metal layer stack 108. The antenna element 112 may be configured to align the main radiation direction of the antenna element 112 in direction of the substrate 102. The second side 106 of the substrate 102 may be configured as a dielectric resonator 114.

The metal layer stack 108 may further include a ground plane 116. The ground plane 116 may be associated to any metallization layer of the plurality of metallization layers 110 of the metal layer stack 108.

The antenna element 112 may include at least one radiation slot 118. The at least one radiation slot 118 may include an opening in the metal layer stack 108. In other words, the antenna element 112 may be a slot-based antenna element. The radiation slot 118 may be structured in one of the following shapes: rectangular, tapered, or curved. The dielectric resonator 114 may be configured to resonate at a target frequency. The target frequency may be in the range from about 30 GHz to about 500 GHz, for example above 60 GHz. The dielectric resonator 114 may be configured to enhance the radiation radiated by the antenna element 112. The dielectric resonator 114 may be structured in one of the following shapes: dipole, square, rectangular, triangular, circle, ring, elliptic, or n-tagonal, such as pentagonal, hexagonal, octagonal etc. The dielectric resonator 114 may be disposed such that the radiation slot 118 is covered by the dielectric resonator 114. According to various embodiments, the dieletric resonator 114 is structured as a square and the planar dimensions of the dielectric resonator 114 may be about a half of the target wavelength times about a half of the target wavelength. The thickness of the dielectric resonator 114 may be selected to define the beam width and/or the bandwidth. The radiation slot 118 may have a length of about one half of the target wavelength. The radiation slot 118 may have a width in the range from about 10 percent to about 15 percent of the length of the radiation slot 118. The antenna element 112 may be configured to radiate through the radiation slot 118. Regarding the impedance matching of the antenna element 112, the size (i.e. length, width) of the radiation slot 118 and the thickness of the dielectric resonator 114 may be considered. The distance between the radiation slot 118 and the dielectric resonator 114 may play no significant role. The antenna element 112 may include at least one slot ground contact via 120. The at least one slot ground contact via 120 may be disposed along the edges of the at least one radiation slot 118. The antenna element 12 may further include at least one transmission line 122. The at least one transmission line 122 may be configured to feed the at least one radiation slot 118. The at least one transmission line 122 may be for example a microstrip line, a coplanar wave guide, or a combination thereof, wherein the combination of a microstrip line and a coplanar wave guide may be a grounded coplanar wave guide. The radiation slot 118 may be disposed one or more metallization layers of the metal layer stack 108 below, i.e. in direction of the substrate 102, the metallization layer the transmission line 122 is disposed in. The antenna element 112 may include at least one shorting pin 124. The at least one shorting pin 124 may be disposed between the at least one transmission line 122 and the at least one radiation slot 118. The antenna element 112 may further include a shorting pin contact via 126. The shorting pin contact via 126 may be disposed between the at least one transmission line 122 and the at least one radiation slot 118. The antenna element 112 may include at least one feeding contact 128. The at least one feeding contact 128 may be configured to feed the at least one transmission line 122. The at least one feeding contact 128 may be disposed in the central part of the semiconductor structure 100. The at least one feeding contact 128 may include at least one feeding contact pad. The at least one feeding contact 128 may be disposed at the surface of the metal layer stack 108 and may be disposed in at least one metallization layer of the plurality of metallization layers 110 of the metal layer stack 108. In other words, the at least one feeding contact 128 is disposed such that the feeding contact 128 can be contacted on top of the surface of the metal layer stack 108, for example contacted such that the feeding contact 128 can be fed by a radio wave. The antenna element 112 may further include at least one ground contact 130. The at least one ground contact 130 may include at least one ground contact pad. The antenna element 112 may further include at least one ground contact via 132. The at least one ground contact via 132 may be configured to connect the at least one ground contact 130 to the ground plane 116. The at least one ground contact via 132 may be configured to electrically connect, i.e. electrically couple, the at least one ground contact 130 to the ground plane 116. The antenna element 112 may further include at least one antenna opening structure 134.

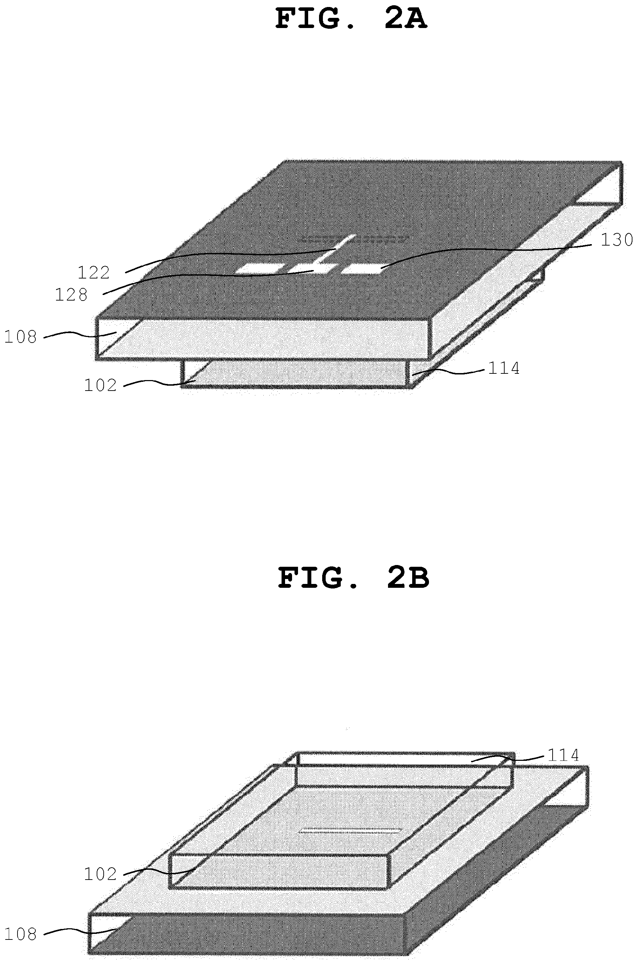

**FIG. 2A** shows a top view of a semiconductor structure 100 according to various embodiments and **FIG. 2B** shows a bottom view of a semiconductor structure 100 according to various embodiments.

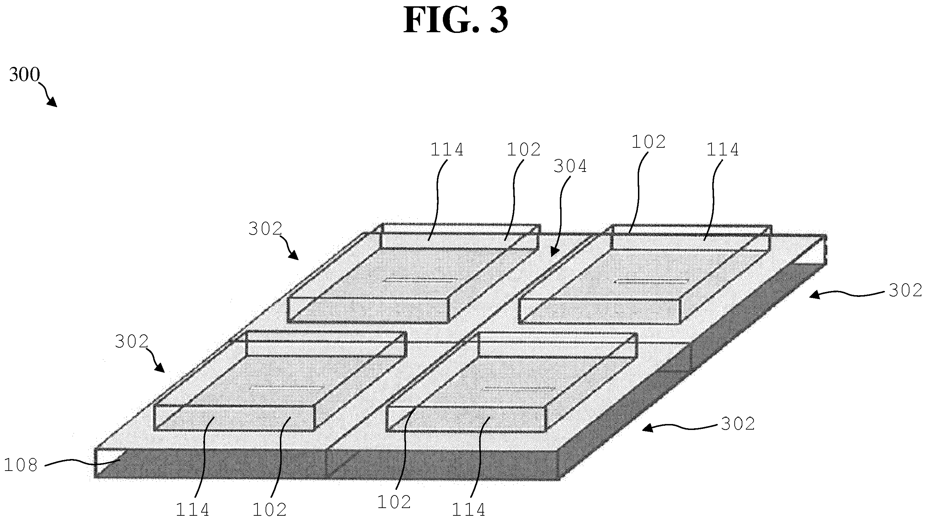

**FIG. 3** shows a semiconductor structure 300 according to various embodiments. The semiconductor structure 300 may include a plurality of structural elements 302, wherein each structural element of the plurality of structural elements 302 may correspond to the semiconductor structure 100. Illustratively, the semiconductor structure 300 may include a plurality of the semiconductor structures 100. In other words, the semiconductor structure 300 may include a plurality of antenna elements, wherein each antenna element of the plurality of antenna elements may correspond to the antenna element 112. In even other words, the metal layer stack 108 disposed over the first side 104 of the substrate 102 may include a plurality of antenna elements and the substrate 102 may be configured as a plurality of dielectric resonators, wherein each dielectric resonator of the plurality of dielectric resonators may be disposed above an antenna element of the plurality of antenna elements. The plurality of dielectric resonators may form an array of dielectric resonators. The array of dielectric resonators may be an array of NxM structural elements 302, wherein each, N and M, may be any natural numbers (for example an array of 1x4, 8x1, 6x2, 3x3 etc. structural elements 302). N and M may be a multiple of two. N and M may be equal.

The semiconductor structure 300 may include a substrate opening structure 304. The substrate opening structure 304 may be disposed such that each dielectric resonator of the plurality of dielectric resonators is separated from any other dielectric resonator of the plurality of dielectric resonators.

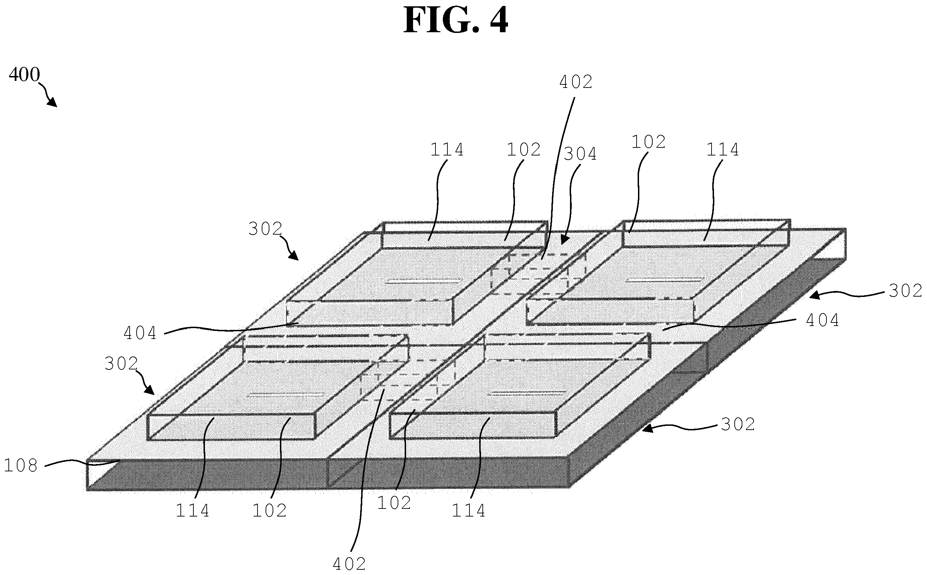

**FIG. 4** shows a semiconductor structure 400 according to various embodiments. The semiconductor structure 400 may correspond substantially to the semiconductor structure 300, wherein the substrate opening structure 304 may include an interconnection structure. The interconnection structure may include at least one substrate rail 402, 404. The at least one substrate rail 402, 404 may be disposed between two adjacent dielectric resonators of the plurality of dielectric resonators. The at least one substrate rail 402, 404 may be in contact with the two adjacent dielectric resonators. A substrate rail may be disposed between the centerlines of two adjacent dielectric resonators or a substrate rail may be disposed between the edge lines of two adjacent dielectric resonators.

According to various embodiments, the interconnection structure includes a plurality of substrate rails, wherein each substrate rail of the plurality of substrate rails may be disposed between two adjacent dielectric resonators of the plurality of dielectric resonators. The plurality of substrate rails may include first substrate rails 402 and second substrate rails 404, wherein the first substrate rails 402 may be disposed between the centerlines of two adjacent dielectric resonators, and wherein the second substrate rails 404 may be disposed between the edge lines of two adjacent dielectric resonators. The interconnection structure has the effect of stabilizing the semiconductor structure. The plurality of dielectric resonators may form an array of dielectric resonators and the interconnection structure may include first substrate rails 402 in a first direction of the array of dielectric resonators and may include second substrate rails 404 in a second direction of the array of dielectric resonators. The first direction of the array of dielectric resonators may be orthogonal to the second direction of the array of dielectric resonators. The first direction of the array of dielectric resonators may be a horizontal in-plane direction and the second direction of the array of dielectric resonators may be a vertical in-plane direction. The semiconductor structure 400 may include at least one dummy dielectric resonator. A dummy dielectric resonator may correspond substantially to any other dielectric resonator, wherein the dummy dielectric resonator is not associated to an antenna element. The at least one dummy dielectric resonator may be in contact with at least one dielectric resonator of the plurality of dielectric resonators via the interconnection structure. According to various embodiments, the semiconductor structure 400 includes a plurality of dummy dielectric resonators. Each dummy dielectric resonator of the plurality of dummy dielectric resonators may be in contact with at least one dielectric resonator of the plurality of dielectric resonators and/or may be in contact with at least one dummy dielectric resonator via the interconnection structure. The plurality of dummy dielectric resonators may be substantially surrounding the array of dielectric resonators.

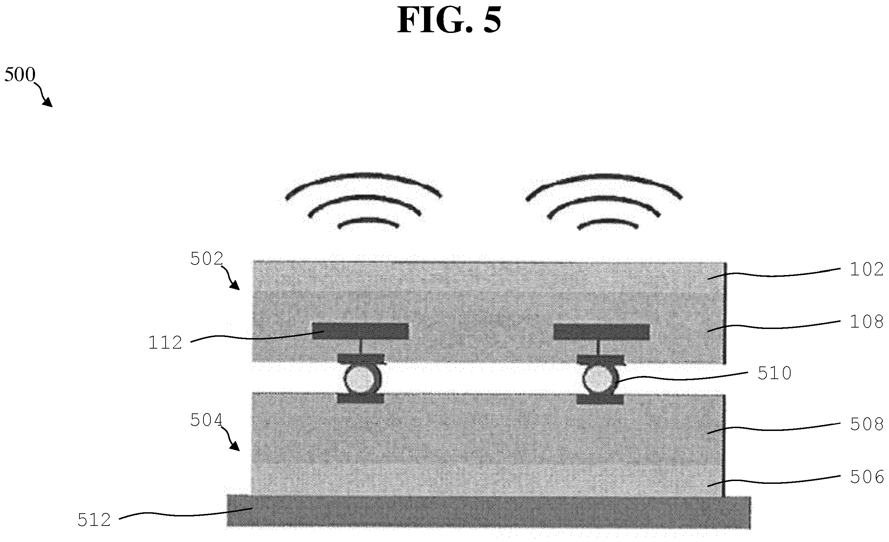

**FIG. 5** shows a system-in-package (SiP) 500 according to various embodiments. The SiP 500 may include an antenna chip 502. The antenna chip 502 may include the semiconductor structure 100, the semiconductor structure 300, and/or the semiconductor structure 400. The SiP 500 may further include a radio frequency integrated circuit chip 504. The radio frequency integrated circuit chip 504 may include a substrate 506. The radio frequency integrated circuit chip 504 may further include a radio frequency integrated circuit. The radio frequency integrated circuit chip 504 may include a radio frequency integrated circuit metal layer stack 508 disposed over the substrate 506 of the radio frequency integrated circuit chip 504. The radio frequency integrated circuit may be disposed at least partially within the substrate 506. The radio frequency integrated circuit may be disposed at least partially in the radio frequency integrated circuit metal layer stack 508. For example, the active electronics of the radio frequency integrated circuit may be disposed in the substrate 506 of the radio frequency integrated circuit chip 504 and the passive electronics of the radio frequency integrated circuit may be disposed in the radio frequency integrated circuit metal layer stack 508. The radio frequency integrated circuit may include a radio frequency transmitter and/or a radio frequency receiver.

The antenna chip 502 may be arranged over the radio frequency integrated circuit chip 504 such that the metal layer stack 108 of the antenna chip is facing the radio frequency integrated circuit of the radio frequency integrated circuit chip 504. In other words, the antenna chip 502 may be arranged over the radio frequency integrated circuit chip 504 such that the metal layer stack 108 of the antenna chip is facing the radio frequency integrated circuit metal layer stack 508.

Between the antenna chip 502 and the radio frequency integrated circuit chip 504 a plurality of solder balls 510 may be disposed. The size of the solder balls 510 may define the distance between the antenna chip 502 and the radio frequency integrated circuit chip 504. The size of the solder balls 510 may be defined such that there is no coupling between the antenna chip 502 and the radio frequency integrated circuit chip 504. The SiP 500 may be attached to a printed circuit board (PCB) 512. The SiP 500 may be attached to the PCB 512 such that the substrate 506 of the radio frequency integrated circuit chip 504 is in contact with the PCB 512.

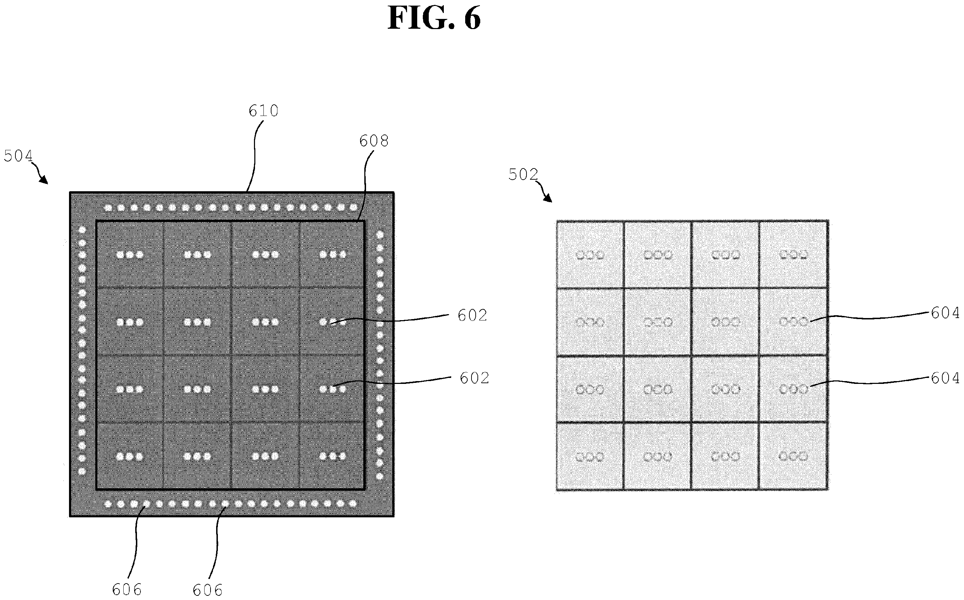

**FIG. 6** shows a top view of an antenna chip 502 and of a radio frequency integrated circuit chip 504 according to various embodiments. The top view of the antenna chip 502 and of a radio frequency integrated circuit chip 504 may show the surface of the respective metal layer stack. The radio frequency integrated circuit chip 504 may include a plurality of radio frequency contacts 602. The antenna chip 502 may include a plurality of feeding contacts 604. Within the SiP 500, a radio frequency contact of the plurality of radio frequency contacts 602 of the radio frequency integrated circuit chip 504 may be aligned to an associated feeding contact of the plurality of feeding contacts 604 of the antenna chip 502. The plurality of radio frequency contacts 602 of the radio frequency integrated circuit chip 504 may be contacted, for example coupled, such as electrically coupled or electrically connected (for example by flip-chip contacts), to the plurality of feeding contacts 604 of the antenna chip 502. The plurality of solder balls 510 may be disposed between the plurality of radio frequency contacts 602 of the radio frequency integrated circuit chip 504 and the feeding contacts 604 of the antenna chip 502.

The radio frequency integrated circuit chip 504 may have larger in-plane dimensions than the antenna chip 502. The radio frequency integrated circuit chip 504 may include a first region 608 and a second region 610. The in-plane dimensions of the first region 608 may correspond substantially to the in-plane dimensions of the antenna chip 502. The in-plane dimensions of the second region 610 may be larger than the in-plane dimensions of the first region 608. The in-plane dimensions of the second region 610 may not be in contact with the antenna chip 502.

The radio frequency integrated circuit chip 504 may further include at least one additional contact 606. The at least one additional contact 606 may be one of the following: DC, clock, and/or power supply contact or contacts. The at least one additional contact 606 may be disposed in the second region 610 of the radio frequency integrated circuit chip 504. According to various embodiments, the radio frequency integrated circuit chip 504 may include a plurality of additional contacts.

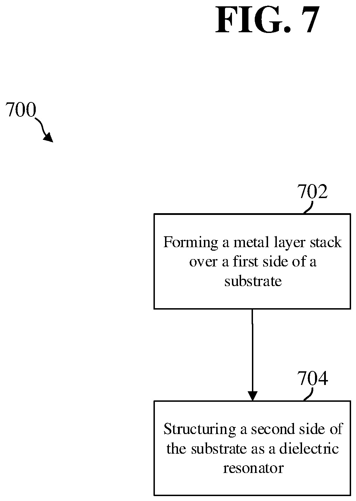

**FIG. 7** shows a method 700 for manufacturing a semiconductor structure according to various embodiments. The method 700 may include forming a metal layer stack 108 over a first side 104 of a substrate 102 (in 702). The metal layer stack 108 may include a plurality of metallization layers 110 and interdielectric layers. An antenna element 112 may be formed in the metal layer stack 108. The antenna element 112 may be configured to align the main radiation of the antenna element 112 in direction of the substrate 102. The method 700 may further include structuring a second side 106 of the substrate 102 as a dielectric resonator 114 (in 704). Structuring the second side 106 of the substrate 102 may include an etching process. The etching process may be a local backside etching process. Structuring the second side 106 of the substrate 102 may further include a wafer thinning process.

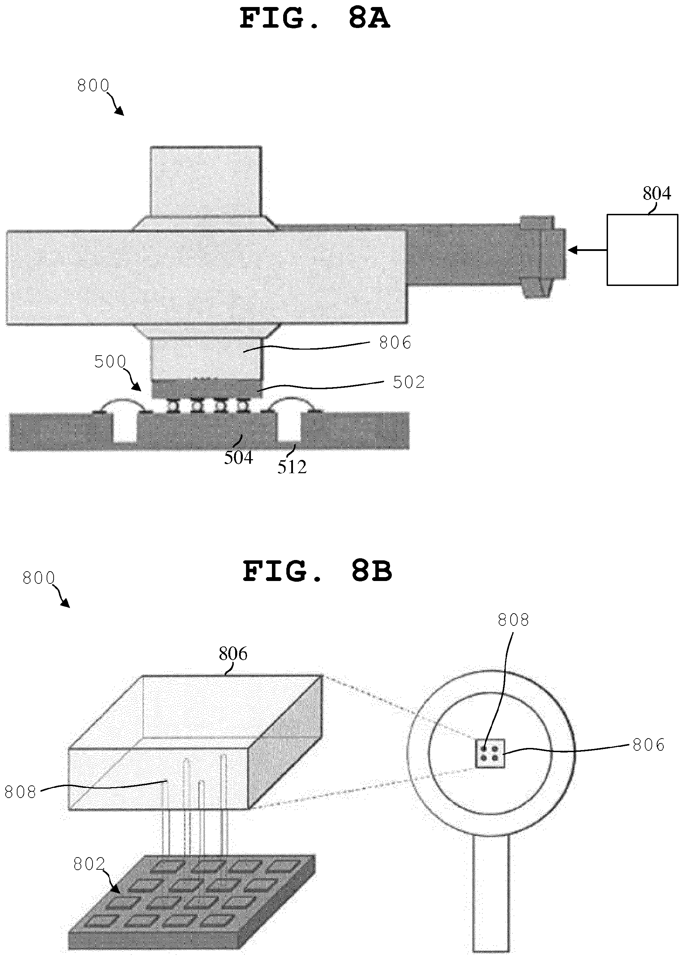

**FIG. 8A** and **FIG. 8B** show a handling tool 800 for handling a chip that includes a semiconductor structure according to various embodiments. The handling tool 800 may be a handling tool handling a chip with a backside structured substrate 802. The backside structured substrate 802 may include a plurality of dielectric resonators. The handling tool 800 may include a pumping system 804. The handling tool 800 may further include a suction head 806. The suction head 806 may include a plurality of suction points 808. The plurality of suction points 808 may be configured to contact the backside structured substrate 802. The plurality of suction points 808 may be further configured that upon contact the structures (for example the plurality of dielectric resonators) of the backside structured substrate 802 cover the suction points 808 completely. In other words, the size (for example diameter) of the suction points 808 is less than the size (for example diameter) of the structures (for example the dielectric resonators) of the backside structured substrate 802. In even other words, the backside structured substrate 802 may include a plurality of structures (a plurality of structural elements), wherein the suction head 806 may be in contact with the structures (structural elements) of the backside structured substrate 802, and wherein upon contact each suction point of the plurality of suction points 808 may be covered completely by one structure (one structural element, for example one dielectric resonator) of the plurality of structures (plurality of structural elements). The pumping system 804 may be configured to generate a vacuum at the suction points 808. This has the effect that the contact between the suction points 808 and the chip, i.e. the backside structured substrate 802, is ensured upon movement of the handling tool 800. In other words, the handling tool 800 may be further configured to move, i.e. to handle, the chip that includes the semiconductor structure.

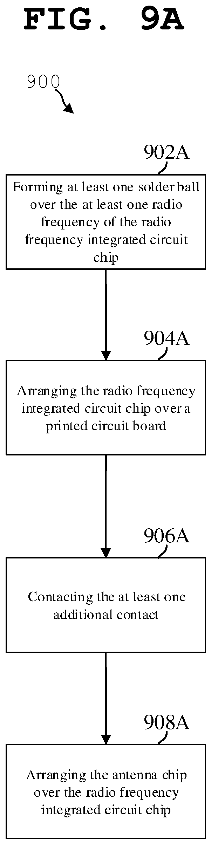

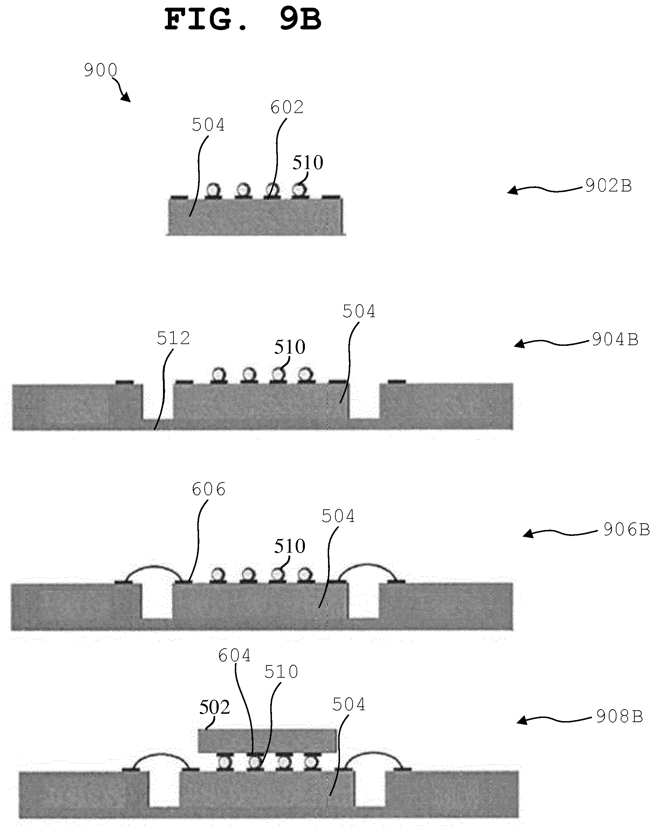

**FIG. 9A** and **FIG. 9B** show a method 900 for mounting an antenna chip and a radio frequency integrated circuit chip on a printed circuit board according to various embodiments, wherein the method 900 is shown illustratively in FIG. 9B. The antenna chip may correspond substantially to the antenna chip 502, wherein at least one feeding contact 128 is disposed on top of the metal layer stack 108. The radio frequency integrated circuit chip may correspond substantially to the radio frequency integrated circuit chip 504, wherein the radio frequency integrated circuit chip 504 includes the first region 608 and the second region 610, wherein the in-plane dimensions of the first region 608 correspond to the in-plane dimensions of the antenna chip 502, and wherein the radio frequency integrated circuit chip 504 includes at least one radio frequency contact 602 in the first region 608 and at least one additional contact 606 disposed in the second region 610.

The method 900 may include forming at least one solder ball 510 over the at least one radio frequency contact 602 of the radio frequency integrated circuit chip 504 (in 902A, 902B). The method 900 may further include arranging the radio frequency integrated circuit chip 504 over a printed circuit board (PCB) 512 (in 904A, 904B). The method 900 may include contacting the at least one additional contact 606 of the radio frequency integrated circuit chip 504 (in 906A, 906B). The at least one additional contact 606 may be contacted using wire bonding. The method 900 may include arranging the antenna chip 502 over the radio frequency integrated circuit chip 504 (in 908A, 908B). The antenna chip 502 may be arranged over the radio frequency integrated circuit chip 504 such that the at least one solder ball 510 is contacting the at least one feeding contact 604 of the antenna chip 502. The antenna chip 502 may be arranged over the radio frequency integrated circuit chip 504 such that the antenna chip 502 is arranged above the first region 608 of the radio frequency integrated circuit chip 504 and/or not above the second region 610 of the radio frequency integrated circuit chip 504. The radio frequency integrated circuit chip 504 may be arranged over the PCB 512 by arranging the radio frequency integrated circuit chip 504 in a cavity of the PCB 512. The antenna chip 502 may be arranged over the radio frequency integrated circuit chip 504 using a flip-chip bonding process. According to various embodiments, the method 900 may further include depositing material with high electrical resistivity and low coupling properties over the radio frequency integrated circuit chip 504 before arranging the antenna chip 502 over the radio frequency integrated circuit chip 504.

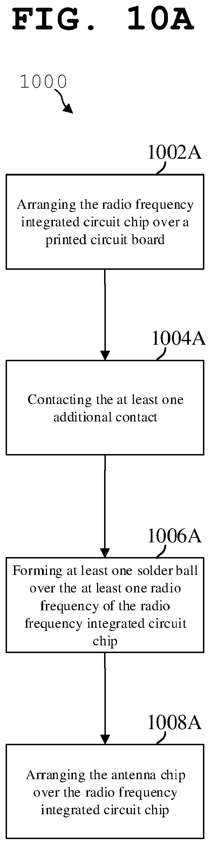

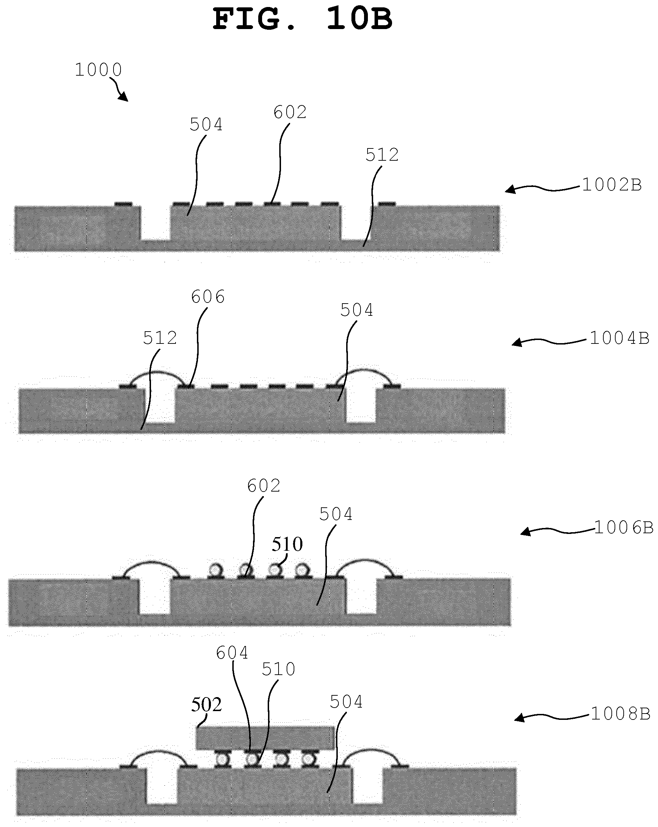

**FIG. 10A** and **FIG. 10B** show a method 1000 for mounting an antenna chip and a radio frequency integrated circuit chip on a printed circuit board according to various embodiments, wherein the method 1000 is shown illustratively in FIG. 10B. The antenna chip may correspond substantially to the antenna chip 502, wherein at least one feeding contact 128 is disposed on top of the metal layer stack 108. The radio frequency integrated circuit chip may correspond substantially to the radio frequency integrated circuit chip 504, wherein the radio frequency integrated circuit chip 504 includes the first region 608 and the second region 610, wherein the in-plane dimensions of the first region 608 correspond to the in-plane dimensions of the antenna chip 502, and wherein the radio frequency integrated circuit chip 504 includes at least one radio frequency contact 602 in the first region 608 and at least one additional contact 606 disposed in the second region 610.

The method 1000 may include arranging the radio frequency integrated circuit chip 504 over a printed circuit board (PCB) 512 (in 1002A, 1002B). The method 1000 may further include contacting the at least one additional contact 606 of the radio frequency integrated circuit chip 504 (in 1004A, 1004B). The at least one additional contact 606 may be contacted using wire bonding. The method 900 may include forming at least one solder ball 510 over the at least one radio frequency contact 602 of the radio frequency integrated circuit chip 504 (in 1006A, 1006B). The method 900 may include arranging the antenna chip 502 over the radio frequency integrated circuit chip 504 (in 908A, 908B. The antenna chip 502 may be arranged over the radio frequency integrated circuit chip 504 such that the at least one solder ball 510 is contacting the at least one feeding contact 604 of the antenna chip 502. The antenna chip 502 may be arranged over the radio frequency integrated circuit chip 504 such that the antenna chip 502 is arranged above the first region 608 of the radio frequency integrated circuit chip 504 and/or not above the second region 610 of the radio frequency integrated circuit chip 504. The radio frequency integrated circuit chip 504 may be arranged over the PCB 512 by arranging the radio frequency integrated circuit chip 504 in a cavity of the PCB 512. The antenna chip 502 may be arranged over the radio frequency integrated circuit chip 504 using a flip-chip bonding process. According to various embodiments, the method 1000 may further include depositing material with high electrical resistivity and low coupling properties over the radio frequency integrated circuit chip 504 before arranging the antenna chip 502 over the radio frequency integrated circuit chip 504.

## Claims

1. A semiconductor structure (100), comprising:
• a substrate (102), comprising a first side (104) and a second side (106), wherein the substrate (102) comprises a semiconductor material;
• a metal layer stack (108) disposed over the first side (104) of the substrate (102), wherein the metal layer stack (108) comprises a plurality of metallization layers (110) and interdielectric layers and wherein an antenna element (112) is formed in the metal layer stack (108);
• wherein the antenna element (112) is configured to align the main radiation direction of the antenna element (112) in direction of the substrate (102); and
• wherein the second side (106) of the substrate (102) is configured as a dielectric resonator (114).

2. The semiconductor structure (100) of claim 1, wherein the dielectric resonator (114) enhances the radiation radiated by the antenna element (112).

3. The semiconductor structure (100) of any one of the claims 1 or 2, wherein the dielectric resonator (114) is structured in one of the following shapes: dipole, square, rectangular, triangular, circle, ring, elliptic, or n-tagonal, such as pentagonal, hexagonal, octagonal etc.

4. The semiconductor structure (100) of any one of claims 1 to 3, wherein the second side (106) of the substrate (102) comprises a plurality of dielectric resonators and wherein the plurality of dielectric resonators optionally forms an array of dielectric resonators.

5. An antenna chip comprising the semiconductor structure (100) of any one of the claims 1 to 4.

6. A system-in-package, comprising an antenna chip according to claim 5 and a radio frequency integrated circuit chip,
wherein the radio frequency integrated circuit chip comprises a substrate, a radio frequency integrated circuit disposed at least partially within the substrate; and
wherein the antenna chip is arranged over the radio frequency integrated circuit chip such that the metal layer stack of the antenna chip is facing the radio frequency integrated circuit of the radio frequency integrated circuit chip.

7. A method for manufacturing a semiconductor structure, the method comprising:
• Forming a metal layer stack (108) over a first side (104) of a semiconductor substrate (102), wherein the metal layer stack (108) comprises a plurality of metallization layers (110) and interdielectric layers and wherein an antenna element (112) is formed in the metal layer stack (108), wherein the antenna element (112) is configured to align the main radiation direction of the antenna element (112) in direction of the substrate (102);
• Structuring a second side (106) of the semiconductor substrate (102) as a dielectric resonator (114).

8. The method of claim 7, wherein the structuring of the second side (106) of the substrate (102) comprises an etching process.

9. The method of claim 8, wherein the etching process is a local backside etching process.

10. The method of any one of claim 7 to 9, further comprising a wafer thinning process.

11. A method for mounting an antenna chip according to claim 5 and a radio frequency integrated circuit chip on a printed circuit board,
wherein the antenna chip further comprises at least one feeding contact disposed on top of the metal layer stack; wherein the radio frequency integrated circuit chip comprises:
• a substrate, comprising a first side and a second side;
• a radio frequency integrated circuit disposed at least partially over the first side of the substrate;
• a first region and a second region of the radio frequency integrated circuit, wherein the in-plane dimensions of the first region correspond to the in-plane dimensions of the antenna chip;
• wherein the radio frequency integrated circuit comprises at least one radio frequency contact in the first region and at least one additional contact, wherein the at least one additional contact is disposed in the second region;
and wherein the method comprises:
• Forming at least one solder ball over the at least one radio frequency contact of the radio frequency integrated circuit chip;
• Arranging the radio frequency integrated circuit chip over a printed circuit board;
• Contacting the at least one additional contact;
• Arranging the antenna chip over the radio frequency integrated circuit chip such that the at least one solder ball is contacting the at least one feeding contact of the antenna chip.

12. A method for mounting an antenna chip according to claim 5 and a radio frequency integrated circuit chip on a printed circuit board,
wherein the antenna chip further comprises at least one feeding contact disposed on top of the metal layer stack; wherein the radio frequency integrated circuit chip comprises:
• a substrate, comprising a first side and a second side;
• a radio frequency integrated circuit disposed at least partially over the first side of the substrate;
• a first region and a second region of the radio frequency integrated circuit, wherein the in-plane dimensions of the first region correspond to the in-plane dimensions of the antenna chip;
• wherein the radio frequency integrated circuit comprises at least one radio frequency contact in the first region and at least one additional contact, wherein the at least one additional contact is disposed in the second region;
and wherein the method comprises:
• Arranging the radio frequency integrated circuit chip over a printed circuit board;
• Contacting the at least one additional contact;
• Forming at least one solder ball over the at least one radio frequency contact of the radio frequency integrated circuit chip;
• Arranging the antenna chip over the radio frequency integrated circuit chip such that the at least one solder ball is contacting the at least one feeding contact of the antenna chip.

## Patentansprüche

1. Eine Halbleiterstruktur (100), aufweisend:
• ein Substrat (102), das eine erste Seite (104) und eine zweite Seite (106) aufweist, wobei das Substrat (102) ein Halbleiter-Material aufweist;
• einen Metallschichtstapel (108), der über der ersten Seite (104) des Substrats (102) angeordnet ist, wobei der Metallschichtstapel (108) eine Mehrzahl von Metallisierungsschichten (110) und Zwischendielektrikums-Schichten aufweist und wobei ein Antennen-Element (112) in dem Metallschichtstapel (108) gebildet ist;
• wobei das Antennen-Element (112) eingerichtet ist, die Hauptabstrahlrichtung des Antennen-Elements (112) in Richtung des Substrats (102) auszurichten; und
• wobei die zweite Seite (106) des Substrats (102) als ein dielektrischer Resonator (114) eingerichtet ist.

2. Die Halbleiterstruktur (100) nach Anspruch 1, wobei der dielektrische Resonator (114) die mittels des Antennen-Elements (112) abgestrahlte Strahlung verstärkt.

3. Die Halbleiterstruktur (100) nach einem der Ansprüche 1 oder 2, wobei der dielektrische Resonator (114) in einer der folgenden Formen strukturiert ist: Dipol, Quadrat, rechteckig, dreieckig, Kreis, Ring, elliptisch, oder n-eckig, wie beispielsweise fünfeckig, sechseckig, achteckig etc.

4. Die Halbleiterstruktur (100) nach einem der Ansprüche 1 bis 3, wobei die zweite Seite (106) des Substrats (102) eine Mehrzahl von dielektrischen Resonatoren aufweist und wobei die Mehrzahl von dielektrischen Resonatoren optional ein Array dielektrischer Resonatoren bildet.

5. Ein Antennen-Chip, aufweisend die Halbleiterstruktur (100) nach einem der Ansprüche 1 bis 4.

6. Ein System-in-Package, aufweisend einen Antennen-Chip gemäß Anspruch 5 und einen integrierten Funkfrequenz-Schaltungs-Chip,
wobei der integrierte Funkfrequenz-Schaltungs-Chip aufweist: ein Substrat, eine zumindest teilweise in dem Substrat angeordnete integrierte Funkfrequenz-Schaltung; und
wobei der Antennen-Chip derart über dem integrierten Funkfrequenz-Schaltungs-Chip angeordnet ist, dass der Metallschichtstapel des Antennen-Chips der integrierten Funkfrequenz-Schaltung des integrierten Funkfrequenz-Schaltungs-Chips zugewandt ist.

7. Ein Verfahren zum Herstellen einer Halbleiterstruktur, das Verfahren aufweisend:
• Bilden eines Metallschichtstapels (108) über einer ersten Seite (104) eines Halbleiter-Substrats (102), wobei der Metallschichtstapel (108) eine Mehrzahl von Metallisierungsschichten (110) und Zwischendielektrikums-Schichten aufweist und wobei ein Antennen-Element (112) in dem Metallschichtstapel (108) gebildet wird, wobei das Antennen-Element (112) eingerichtet ist, die Hauptabstrahlrichtung des Antennen-Elements (112) in Richtung des Substrats (102) auszurichten;
• Strukturieren einer zweiten Seite (106) des Halbleiter-Substrats (102) als einen dielektrischen Resonator (114).

8. Das Verfahren nach Anspruch 7, wobei das Strukturieren der zweiten Seite (106) des Substrats (102) einen Ätzprozess aufweist.

9. Das Verfahren nach Anspruch 8, wobei der Ätzprozess ein lokaler Rückseiten-Ätzprozess ist.

10. Das Verfahren nach einem der Ansprüche 7 bis 9, ferner aufweisend einen Wafer-Dünnungs-Prozess.

11. Ein Verfahren zum Anbringen eines Antennen-Chips gemäß Anspruch 5 und eines integrierten Funkfrequenz-Schaltungs-Chips auf einer gedruckten Leiterplatte,
wobei der Antennen-Chip ferner mindestens einen Einspeisungs-Kontakt aufweist, der auf dem Metallschichtstapel angeordnet ist;
wobei der integrierte Funkfrequenz-Schaltungs-Chip aufweist:
• ein Substrat, das eine erste Seite und eine zweite Seite aufweist;
• eine integrierte Funkfrequenz-Schaltung, die zumindest teilweise über der ersten Seite des Substrats angeordnet ist;
• einen ersten Bereich und einen zweiten Bereich der integrierten Funkfrequenz-Schaltung, wobei die In-Ebene-Dimensionen des ersten Bereichs den In-Ebene-Dimensionen des Antennen-Chips entsprechen;
• wobei die integrierte Funkfrequenz-Schaltung mindestens einen Funkfrequenz-Kontakt in dem ersten Bereich und mindestens einen zusätzlichen Kontakt aufweist, wobei der mindestens eine zusätzliche Kontakt in dem zweiten Bereich angeordnet ist;
und wobei das Verfahren aufweist:
• Bilden mindestens einer Lötkugel über dem mindestens einen Funkfrequenz-Kontakt des integrierten Funkfrequenz-Schaltungs-Chips;
• Anordnen des integrierten Funkfrequenz-Schaltungs-Chips über einer gedruckten Leiterplatte;
• Kontaktieren des mindestens einen zusätzlichen Kontakts;
• Anordnen des Antennen-Chips über dem integrierten Funkfrequenz-Schaltungs-Chip derart, dass die mindestens eine Lötkugel den mindestens einen Einspeisungs-Kontakt des Antennen-Chips kontaktiert.

12. Ein Verfahren zum Anbringen eines Antennen-Chips gemäß Anspruch 5 und eines integrierten Funkfrequenz-Schaltungs-Chips auf einer gedruckten Leiterplatte,
wobei der Antennen-Chip ferner mindestens einen Einspeisungs-Kontakt aufweist, der auf dem Metallschichtstapel angeordnet ist;
wobei der integrierte Funkfrequenz-Schaltungs-Chip aufweist:
• ein Substrat, das eine erste Seite und eine zweite Seite aufweist;
• eine integrierte Funkfrequenz-Schaltung, die zumindest teilweise über der ersten Seite des Substrats angeordnet ist;
• einen ersten Bereich und einen zweiten Bereich der integrierten Funkfrequenz-Schaltung, wobei die In-Ebene-Dimensionen des ersten Bereichs den In-Ebene-Dimensionen des Antennen-Chips entsprechen;
• wobei die integrierte Funkfrequenz-Schaltung mindestens einen Funkfrequenz-Kontakt in dem ersten Bereich und mindestens einen zusätzlichen Kontakt aufweist, wobei der mindestens eine zusätzliche Kontakt in dem zweiten Bereich angeordnet ist;
und wobei das Verfahren aufweist:
• Anordnen des integrierten Funkfrequenz-Schaltungs-Chips über einer gedruckten Leiterplatte;
• Kontaktieren des mindestens einen zusätzlichen Kontakts;
• Bilden mindestens einer Lötkugel über dem mindestens einen Funkfrequenz-Kontakt des integrierten Funkfrequenz-Schaltungs-Chips;
• Anordnen des Antennen-Chips über dem integrierten Funkfrequenz-Schaltungs-Chip derart, dass die mindestens eine Lötkugel den mindestens einen Einspeisungs-Kontakt des Antennen-Chips kontaktiert.

## Revendications

1. Structure semi-conductrice (100), comprenant :
• un substrat (102), comprenant un premier côté (104) et un deuxième côté (106), dans lequel le substrat (102) comprend un matériau semi-conducteur ;
• un empilement de couches métalliques (108) disposé sur le premier côté (104) du substrat (102), où l'empilement de couches métalliques (108) comprend une pluralité de couches de métallisation (110) et de couches inter-diélectriques et où un élément d'antenne (112) est formé dans l'empilement de couches métalliques (108) ;
• où l'élément d'antenne (112) est configuré pour aligner la direction de rayonnement principale de l'élément d'antenne (112) en direction du substrat (102) ; et
• où le deuxième côté (106) du substrat (102) est configuré comme un résonateur diélectrique (114).

2. Structure semi-conductrice (100) selon la revendication 1, dans laquelle le résonateur diélectrique (114) renforce le rayonnement émis par l'élément d'antenne (112).

3. Structure semi-conductrice (100) selon l'une quelconque des revendications 1 ou 2, dans laquelle le résonateur diélectrique (114) est structuré selon l'une des formes suivantes : dipôle, carré, rectangulaire, triangulaire, cercle, anneau, elliptique ou n-tagonale, telle que pentagonale, hexagonale, octogonale, etc.

4. Structure semi-conductrice (100) selon l'une quelconque des revendications 1 à 3, dans laquelle le deuxième côté (106) du substrat (102) comprend une pluralité de résonateurs diélectriques et dans laquelle la pluralité de résonateurs diélectriques forment éventuellement un réseau de résonateurs diélectriques.

5. Puce d'antenne, comprenant la structure semi-conductrice (100) selon l'une quelconque des revendications 1 à 4.

6. Système en boîtier, comprenant une puce d'antenne selon la revendication 5 et une puce de circuit intégré de radiofréquence,
dans lequel la puce de circuit intégré de radiofréquence comprend un substrat, un circuit intégré de radiofréquence disposé au moins partiellement à l'intérieur du substrat ; et
dans lequel la puce d'antenne est disposée sur la puce de circuit intégré de radiofréquence de sorte que l'empilement de couches métalliques de la puce d'antenne fait face au circuit intégré de radiofréquence de la puce de circuit intégré de radiofréquence.

7. Procédé de fabrication d'une structure semi-conductrice, le procédé comprenant les étapes suivantes consistant à :
• former un empilement de couches métalliques (108) sur un premier côté (104) d'un substrat semi-conducteur (102), dans lequel l'empilement de couches métalliques (108) comprend une pluralité de couches de métallisation (110) et de couches inter-diélectriques et dans lequel un élément d'antenne (112) est formé dans l'empilement de couches métalliques (108), dans lequel l'élément d'antenne (112) est configuré pour aligner la direction de rayonnement principale de l'élément d'antenne (112) en direction du substrat (102) ;
• structurer un deuxième côté (106) du substrat semi-conducteur (102) comme un résonateur diélectrique (114).

8. Procédé selon la revendication 7, dans lequel l'étape de structurer le deuxième côté (106) du substrat (102) comprend un processus de gravure.

9. Procédé selon la revendication 8, dans lequel le processus de gravure est un processus de gravure locale de face arrière.

10. Procédé selon l'une quelconque des revendications 7 à 9, comprenant en outre un processus d'amincissement de plaquette.

11. Procédé de montage d'une puce d'antenne selon la revendication 5 et d'une puce de circuit intégré de radiofréquence sur une carte de circuit imprimé,
dans lequel la puce d'antenne comprend en outre au moins un contact d'alimentation disposé en haut de l'empilement de couches métalliques ;
dans lequel la puce de circuit intégré de radiofréquence comprend :
• un substrat, comprenant un premier côté et un deuxième côté ;
• un circuit intégré de radiofréquence disposé au moins partiellement sur le premier côté du substrat ;
• une première région et une deuxième région du circuit intégré de radiofréquence, où les dimensions dans le plan de la première région correspondent aux dimensions dans le plan de la puce d'antenne ;
• dans lequel le circuit intégré de radiofréquence comprend au moins un contact de radiofréquence dans la première région et au moins un contact supplémentaire, dans lequel ledit au moins un contact supplémentaire est disposé dans la deuxième région ;
et dans lequel le procédé comprend les étapes consistant à :
• former au moins une bille de soudure sur ledit au moins un contact de radiofréquence de la puce de circuit intégré de radiofréquence ;
• agencer la puce de circuit intégré de radiofréquence sur une carte de circuit imprimé ;
• contacter ledit au moins un contact supplémentaire ;
• agencer la puce d'antenne sur la puce de circuit intégré de radiofréquence de telle sorte que ladite au moins une bille de soudure contacte ledit au moins un contact d'alimentation de la puce d'antenne.

12. Procédé de montage d'une puce d'antenne selon la revendication 5 et d'une puce de circuit intégré de radiofréquence sur une carte de circuit imprimé,
dans lequel la puce d'antenne comprend en outre au moins un contact d'alimentation disposé en haut de l'empilement de couches métalliques ;
dans lequel la puce de circuit intégré de radiofréquence comprend :
• un substrat, comprenant un premier côté et un deuxième côté ;
• un circuit intégré de radiofréquence disposé au moins partiellement sur le premier côté du substrat ;
• une première région et une deuxième région du circuit intégré de radiofréquence, où les dimensions dans le plan de la première région correspondent aux dimensions dans le plan de la puce d'antenne ;
• dans lequel le circuit intégré de radiofréquence comprend au moins un contact de radiofréquence dans la première région et au moins un contact supplémentaire, dans lequel ledit au moins un contact supplémentaire est disposé dans la deuxième région ;
et dans lequel le procédé comprend les étapes consistant à :
• agencer la puce de circuit intégré de radiofréquence sur une carte de circuit imprimé ;
• contacter ledit au moins un contact supplémentaire ;
• former au moins une bille de soudure sur ledit au moins un contact de radiofréquence de la puce de circuit intégré de radiofréquence ;
• agencer la puce d'antenne sur la puce de circuit intégré de radiofréquence de sorte que ladite au moins une bille de soudure contacte ledit au moins un contact d'alimentation de la puce d'antenne.
